# FASCICULE DE BREVET EUROPEEN

(11) **EP 0 840 378 B1**
(45) Date de publication et mention de la délivrance du brevet: **10.03.1999**
(21) Numéro de dépôt: 97402588.4
(22) Date de dépôt: 30.10.1997
(51) Int. Cl.: H01L 27/112, H01L 21/8246

(54) **Mémoire ROM et procédé de fabrication correspondant en technologie MOS**
ROM-Speicher und Verfahren zu seiner Herstellung in MOS-Technologie
Read-only memory and manufacturing method in MOS-technology

(30) Priorité: 31.10.1996 FR 9613372
(43) Date de publication de la demande: 06.05.1998
(73) Titulaire: STMicroelectronics S.A., 94250 Gentilly (FR)
(72) Inventeur: Fournel, Richard, 94230 Cachan (FR); Boivin, Philippe, 94230 Cachan (FR)
(74) Mandataire: Ballot, Paul

(56) Documents cités:
- EP-A- 0 302 659
- EP-A- 0 575 688
- US-A- 5 480 823

## Description

La présente invention concerne une mémoire ROM et un procédé de fabrication correspondant en technologie MOS.

Dans l'état de la technique, on connaît différents types de cellules mémoires ROM qui utilisent à la base un transistor MOS. Une étape particulière dans le procédé de fabrication va modifier ce transistor pour obtenir un fonctionnement différent entre la cellule de base et la cellule programmée à laquelle l'étape particulière a été appliquée.

On connaît ainsi une méthode de programmation par contacts, qui consiste simplement à contacter en métal la grille du transistor, tandis que dans la cellule de base, cette grille ne sera pas contactée. C'est en général ce type de cellules que l'on trouve dans les réseaux logiques programmables. Le codage est facilement détectable puisqu'il suffit de regarder où sont les contacts métal (Aluminium). Et la cellule est relativement encombrante (à cause des contacts métal de grille).

On connaît d'autres procédés qui consistent à agir sur l'une des diffusions du transistor, pour modifier les propriétés de conduction de ces diffusions.

On a ainsi le codage en N⁻ (sur substrat P) dont la cellule de base comprend une diffusion normalement dopée (N⁺) et une diffusion moins dopée (N⁻). Dans la cellule codée, il n'y a que la diffusion normalement dopée (N⁺).

Dans un autre procédé, la cellule de base a une diffusion peu dopée (N⁻) comme précédemment, mais la cellule codée comprend une diffusion de dopage opposé (P) entre cette diffusion peu dopée N⁻ et le canal. C'est le codage par contre dopage P (pour un substrat P).

Tous ces procédés agissant sur les diffusions ont comme inconvénient majeur de ne pas offrir une assez grande différentiation des courants entre la cellule de base et la cellule codée. En effet la cellule passante (cellule de base dans la description ci-dessus) est peu passante, à cause du faible dopage des diffusions, tandis que la cellule codée laisse passer un courant de fuite. Pour ces raisons, une détection sûre nécessite des circuits spécialement conçus pour détecter de faibles différences, dont le temps de réponse reste trop lent.

Par ailleurs, on cherche à diminuer les délais de fabrication. Pour cela, il faut que la partie codage, spécifique au client, intervienne le plus tard possible dans le procédé de fabrication. Moins il restera d'étapes de fabrication à réaliser, plus vite le circuit sera livré au client. Actuellement, il faut six à huit semaines pour terminer un circuit selon les spécifications de codage du client, à partir d'un circuit prêt à être codé. On cherche à diviser par deux ce délai de livraison.

Un objet de l'invention est de proposer une mémoire ROM qui offre une bonne différentiation entre le courant d'une cellule passante et le courant d'une cellule non passante, de manière à avoir une détection sûre et rapide.

Un autre objet de l'invention est de proposer une mémoire ROM pour laquelle le codage client intervient tard dans le procédé de fabrication, de manière à avoir un délai de livraison au client le plus court possible.

Un autre objet de l'invention est de proposer une mémoire ROM dont le codage est difficilement repérable.

Telle que caractérisée l'invention concerne donc un procédé de fabrication de cellules d'une mémoire ROM chaque cellule comprenant un transistor MOS formé d'une première et d'une deuxième diffusion d'un premier type d'impuretés dans un substrat semi-conducteur d'un deuxième type d'impuretés, ces deux diffusions étant séparées par un canal surmonté d'une grille.

Selon l'invention, une zone d'oxyde épais est réalisée dans la zone destinée à la première diffusion, en sorte que la réalisation des diffusions aboutisse à la première diffusion en deux parties séparées par cette zone d'oxyde épais, une première partie (1a) jouxtant le canal et une deuxième partie en périphérie du transistor.

Le procédé de fabrication comprend une étape de codage qui consiste à enlever l'oxyde épais dans chaque cellule à programmer, en sorte que la réalisation des diffusions aboutisse pour ces cellules à une première diffusion en un seul tenant.

La réalisation des contacts électriques prévoit que le contact électrique de la première diffusion soit réalisé sur la deuxième partie (1b).

Les cellules de base, avec les deux parties séparées par l'oxyde épais, ne sont donc pas conductrices. Les cellules programmées sont conductrices et conduisent un fort courant, puisque les deux diffusions de part et d'autre du canal sont dopées normalement.

D'autres caractéristiques et avantages sont détaillés dans la description suivante, faite à titre indicatif et nullement limitatif de l'invention et en référence aux dessins annexés dans lesquels :
- la figure 1 représente une coupe transversale d'une cellule de base d'une mémoire ROM selon l'invention.
- la figure 2 représente une coupe transversale d'une cellule programmée dans une mémoire ROM selon l'invention;
- la figure 3 montre les courbes V_{ds} = f(id) pour les cellules des figures 1 et 2; et
- la figure 4 montre un schéma simplifié de cellules mémoires selon l'invention.

Pour les besoins de la description, on prend l'exemple d'une application à un substrat silicium dopé P. L'oxyde épais concerné est dans ce cas, l'oxyde de silicium.

Une cellule mémoire selon l'invention comprend un transistor MOS par exemple de type N, mais l'invention n'est absolument pas limitée à ce cas. Ce transistor est formé d'une grille G qui surmonte un canal de conduction dans le substrat P. De part et d'autre du canal, on a une première diffusion 1 et une deuxième diffusion 2, du type d'impuretés N opposé au substrat.

Dans l'invention, la cellule mémoire de base comprend une zone d'oxyde épais OX qui sépare en deux parties 1a et 1b la première diffusion. La première partie 1a jouxte le canal de conduction. La deuxième partie 1b est en périphérie du transistor. Un contact électrique C1, C2 est prévu pour la connexion, en diffusion ou à une ligne de métal, de chacune des deux diffusions 1 et 2. Sur la première diffusion 1, ce contact électrique C1 sera plus particulièrement réalisé sur la partie périphérique 1b. Enfin la grille est elle-même connectée, en général par une ligne de polysilicium dont elle est un prolongement.

Si on considère la première diffusion comme le drain et la deuxième diffusion comme la source, on impose, en lecture, une tension Vg sur la grille, une tension de drain Vd sur C1 et une tension de source Vs sur C2. En pratique, la tension Vg est supérieure à la tension de seuil VT du transistor, la tension Vd est de l'ordre de 5 volts et la tension Vs est la masse électrique. Du fait de la zone d'oxyde épais séparant et isolant en deux parties la première diffusion, et comme le contact électrique C1 est réalisé sur la partie périphérique 1b, le courant id de drain résultant est nul.

Pour une éventuelle connexion électrique avec une ligne de métal, une implantation ionique en impuretés N permet de réaliser des zones 3 et 4 plus implantées (N++) sous les contacts C1 et C2, afin d'améliorer le contact électrique avec le métal ainsi que la tenue à la haute tension.

Selon une réalisation classique, on a en outre une zone d'implantation de champ notée P-iso sous la zone d'oxyde épais, c'est à dire une zone avec un dopage important de type P (P⁺) sous cet oxyde.

La réalisation de la zone d'oxyde épais selon l'invention se fait dans une étape habituelle du procédé de fabrication correspondant à la réalisation des oxydes de champ dont le but est habituellement d'isoler les éléments actifs, par exemple, les transistors entre eux.

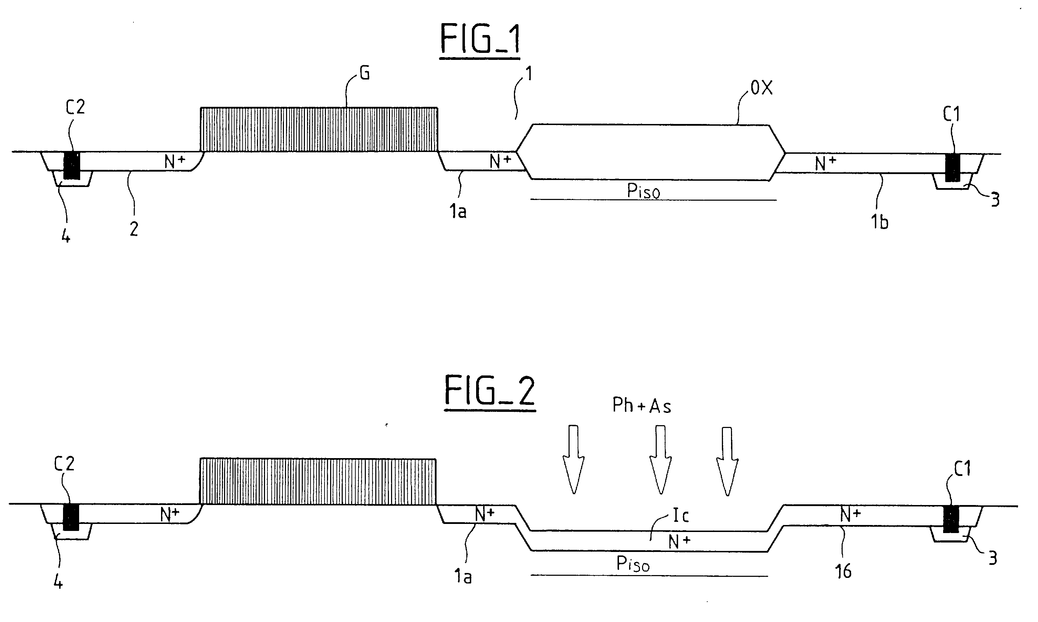

La figure 2 représente la cellule mémoire de l'invention après programmation.

Selon l'invention, pour programmer la cellule de base de la figure 1, on procède tout d'abord à l'enlèvement de la zone d'oxyde épais. Dans le procédé de fabrication de cellules mémoires de l'invention, c'est l'étape de codage qui consiste à enlever l'oxyde épais dans les cellules à programmer, au moyen d'un masque de codage approprié.

L'enlèvement est réalisé par toute technique adaptée comme l'attaque chimique ou ionique.

Cette étape de codage intervient tard dans le procédé de fabrication typiquement dans le dernier tiers de la fabrication.

Une fois l'oxyde épais parti, on peut procéder à l'implantation ionique d'impuretés de type N, typiquement un mélange de Phosphore et d'Arsenic, qui correspond à une ou des étapes habituelles du procédé de fabrication dans lequel seules les zones de type P sont masquées (masque P) . Pour les cellules dans lesquelles l'oxyde épais a été enlevé, cette étape d'implantation permet de réaliser l'implantation d'impuretés de type N dans la zone 1c à la place de cet oxyde épais. L'implantation dans les deux parties la et 1b et 1a zone 1c de la première diffusion, forme ainsi une zone dopée N⁺ continue, c'est à dire en un seul tenant. On notera, comme montré sur les figures 1 et 2, qu'une partie de l'étape d'implantation correspondant aux parties identiques des cellules vierges et programmées peuvent être réalisées avant l'étape de codage. Mais l'étape d'implantation peut aussi se faire entièrement après l'étape de codage. L'invention n'est pas limité par le mode de réalisation des diffusions.

Si on applique les tensions de lectures Vg, Vd et Vs sur cette cellule au moyen des contacts électriques CG, C1 et C2, on obtient un courant id de drain élevé, correspondant au fonctionnement normal du transistor. Le courant est élevé car les deux zones de source et de drain sont normalement dopées N⁺.

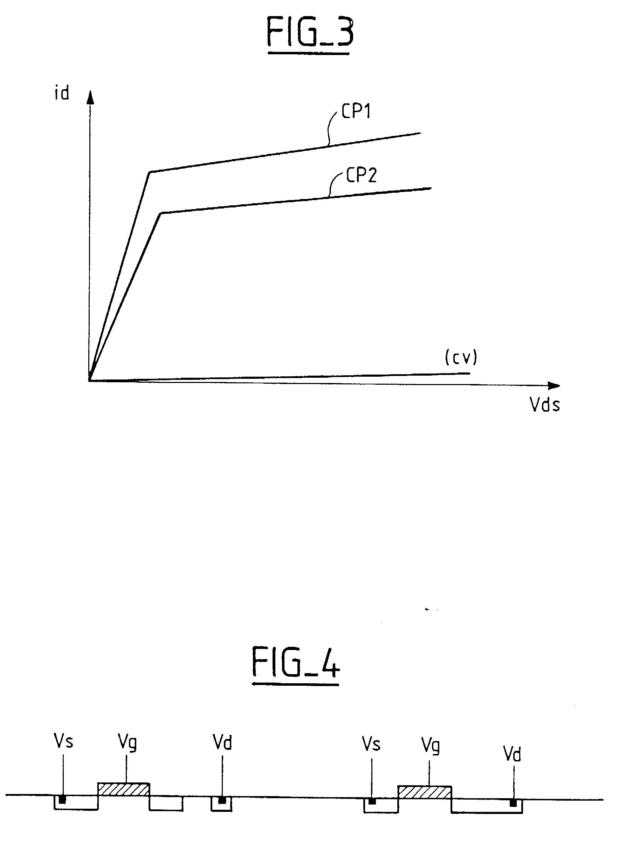

On obtient ainsi les courbes de fonctionnement représentées sur la figure 3. Dans le cas d'une cellule de base, non programmée CV, on a un courant id de drain nul ou très très faible quelle que soit la tension drain-source vds appliquée.

Dans le cas d'une cellule programmée, correspondant à un transistor normal, on obtient un courant id de drain élevé, fonction de la tension drain-source vds appliquée. Ce courant peut varier d'un transistor à l'autre, dans un gabarit donné, schématiquement représenté par les deux courbes CP1 et CP2.

Tout se passe donc comme si dans la cellule vierge, on avait le drain déconnecté, à un potentiel flottant tandis que dans la cellule programmée, on a un transistor normal avec un fonctionnement normal, polarisé normalement.

Dans les réalisations pratiques, il faut prévoir un oxyde épais assez large pour empêcher toute diffusion latérale. En technologie 0,7 micromètre, une distance minimum de 1 micromètre entre la grille et l'oxyde épais et une largeur minimum de 1.4 micromètre pour la zone d'oxyde épais sont à prévoir.

Une mémoire ROM peut ainsi comprendre des cellules mémoires selon l'invention organisée de manière classique matriciellement en lignes et colonnes, les lignes reliant les grilles et les colonnes reliant les drains, les sources des transistors MOS étant reliées à un potentiel commun.

Le codage de cette mémoire intervient tard dans le procédé de fabrication. En effet, après l'étape d'enlèvement de l'oxyde épais pour les cellules à programmer au moyen d'un masque de codage approprié, il ne reste principalement que l'implantation ionique de type N (par le masque P), la réalisation des contacts métal et la passivation. La mémoire selon l'invention offre donc deux avantages majeurs avec une très bonne différentiation des courants entre une cellule non passante (de base) et une cellule passante et un niveau de codage élevé c'est à dire dans les dernières étapes du procédé de fabrication. On dispose alors d'une mémoire morte en circuit intégré, dans laquelle une cellule vierge comprend une zone d'oxyde épais (OX) séparant en deux parties (1a et 1b) la première diffusion, une partie jouxtant le canal et l'autre partie (1b) en périphérie portant le contact de la première diffusion et une cellule programmée comprend une première diffusion en un seul tenant, sans oxyde épais de séparation.

## Revendications

1. Procédé de fabrication de cellules d'une mémoire ROM chaque cellule comprenant un transistor MOS, formé d'une première (1) et d'une deuxième (2) diffusion d'un premier type d'impuretés dans un substrat semi-conducteur d'un deuxième type d'impuretés, ces deux diffusions étant séparées par un canal surmonté d'une grille, le procédé étant caractérisé en ce qu'une zone d'oxyde épais est réalisée dans la zone destinée à la première diffusion (1) de chaque cellule, en sorte que la réalisation des diffusions aboutisse à la première diffusion (1) en deux parties séparées par cette zone d'oxyde épais, une première partie (1a) jouxtant le canal et une deuxième partie (1b) en périphérie du transistor.

2. Procédé de fabrication selon la revendication 1, caractérisé en ce que la zone d'oxyde épais est suffisamment large pour empêcher toute diffusion latérale.

3. Procédé de fabrication selon la revendication 1 ou 2, caractérisé en ce qu'une étape de codage de la mémoire consiste à enlever la zone d'oxyde épais de chaque cellule à programmer au moyen d'un masque de codage approprié, en sorte que la réalisation des diffusions aboutisse pour ces cellules programmées à une première diffusion en une zone continue.

4. Procédé de fabrication selon la revendication 3, caractérisé en ce que l'on réalise un contact électrique (C1) sur la partie périphérique (1b) de la première diffusion (1).

5. Mémoire morte en circuit intégré, chaque cellule de la mémoire comportant un transistor formé d'une première (1) et d'une deuxième diffusion (3) d'un premier type d'impuretés dans un substrat semi-conducteur d'un deuxième type d'impuretés séparées par un canal surmonté d'une grille, un contact électrique (C1, C2) étant prévu sur chacune des diffusions et la grille pour appliquer le cas échéant des tensions de lecture (Vg, Vd, Vs), mémoire caractérisée en ce qu'une cellule vierge comprend une zone d'oxyde épais (OX) séparant en deux parties (1a et 1b) la première diffusion, une partie jouxtant le canal et l'autre partie (1b) périphérique portant le contact électrique (C1) de la première diffusion et en ce qu'une cellule programmée a sa première diffusion en une zone continue.

6. Mémoire selon la revendication 5, caractérisée en ce qu'elle est organisée matriciellement en lignes et colonnes, chaque ligne reliant les grilles de cellules de la mémoire, chaque colonne reliant les premières diffusions de cellules de la mémoire, les deuxièmes diffusions des cellules de la mémoire étant reliées à un même potentiel.

7. Réseau logique programmé comprenant des cellules mémoires selon la revendication 5 ou 6.

## Patentansprüche

1. Verfahren zur Herstellung von Zellen eines ROM-Speichers, wobei jede Zelle einen MOS-Transistor aus einer ersten (1) und einer zweiten (2) Diffusion eines ersten Typs von Verunreinigungen in einem Halbleitersubstrat eines zweiten Typs von Verunreinigungen umfaßt, wobei diese zwei Diffusionen durch einen Kanal voneinander getrennt sind, über dem ein Gate angeordnet ist, wobei das Verfahren
dadurch gekennzeichnet ist, daß
eine dicke Oxidzone in der Zone, die als erste Diffusion (1) jeder Zelle bestimmt ist, realisiert wird, so daß die Realisierung von Diffusionen zu der ersten Diffusion (1) in Form von zwei Teilen, die durch die dicke Oxidzone voneinander getrennt sind, führt, wobei ein erster Teil (1a) an den Kanal angrenzt und ein zweiter Teil (1b) sich am Rand des Transistors befindet.

2. Verfahren zum Herstellen nach Anspruch 1, dadurch gekennzeichnet, daß die dicke Oxidzone ausreichend breit ist, um jede seitliche Diffusion zu verhindern.

3. Herstellungsverfahren nach Anspruch 1 oder 2, dadurch gekennzeichnet, daß ein Codierungsschritt des Speichers darin besteht, die dicke Oxidzone bei jeder zu programmierenden Zelle mittels einer geeigneten Codierungsmaske zu entfernen, so daß die Realisierung von Diffusionen bei den programmierten Zellen zu einer ersten Diffusion als eine durchgehende Zone führt.

4. Herstellungsverfahren nach Anspruch 3, dadurch gekennzeichnet, daß ein elektrischer Kontakt (C1) auf dem Randteil (1b) der ersten Diffusion (1) erzeugt wird.

5. Nur-Lesespeicher in Form eines integrierten Schaltkreises, wobei jede Zelle des Speichers einen Transistor mit einer ersten (1) und einer zweiten (3) Diffusion eines ersten Typs von Verunreinigungen in einem Halbleitersubstrat eines zweiten Typs von Verunreinigungen umfaßt, die durch einen Kanal voneinander getrennt sind, über dem ein Gate angeordnet ist, wobei ein elektrischer Kontakt (C1, C2) auf jeder der Diffusionen und dem Gate vorgesehen ist, um gegebenenfalls Lesespannungen (Vg, Vd, Vs) anzulegen, wobei der Speicher dadurch gekennzeichnet ist, daß eine unbearbeitete Zelle eine dicke Oxidzone (OX) umfaßt, die die erste Diffusion in zwei Teile (1a und 1b) unterteilt, wobei ein Teil an den Kanal angrenzt und der andere Teil (1b) sich am Rand befindet und den elektrischen Kontakt (C1) der ersten Diffusion aufnimmt, und daß eine programmierte Zelle eine erste Diffusion als eine durchlaufende Zone umfaßt.

6. Speicher nach Anspruch 5, dadurch gekennzeichnet, daß er matrixförmig in Zeilen und Spalten unterteilt ist, wobei jede Zeile die Gates der Speicherzellen verbindet, jede Spalte die ersten Diffusionen der Speicherzellen verbindet und die zweiten Diffusionen der Speicherzellen auf dem gleichen Potential liegen.

7. Programmierbare logische Schaltung, die Speicherzellen nach Anspruch 5 oder 6 umfaßt.

## Claims

1. Method of manufacturing cells of an ROM memory, each cell comprising an MOS transistor, formed by a first (1) and a second (2) diffusion of a first type of impurity in a semiconductor substrate of a second type of impurity, these two diffusions being separated by a channel surmounted by a gate, the method being characterised in that a thick oxide region is produced in the region intended for the first diffusion (1) of each cell, so that producing the diffusions results in the first diffusion (1) in two parts separated by this thick oxide region, a first part (1a) abutting the channel and a second part (1b) at the periphery of the transistor.

2. Manufacturing method according to Claim 1, characterised in that the thick oxide region is sufficiently wide to prevent any lateral diffusion.

3. Manufacturing method according to Claim 1 or 2, characterised in that a step of coding the memory consists of removing the thick oxide region of each cell to be programmed by means of a suitable coding mask, so that producing the diffusions results, for these programmed cells, in a first diffusion in a continuous region.

4. Manufacturing method according to Claim 3, characterised in that an electrical contact (C1) is produced on the peripheral part (1b) of the first diffusion (1).

5. Integrated-circuit read only memory, each cell of the memory having a transistor formed by a first (1) and a second (3) diffusion of a first type of impurity in a semiconductor substrate of a second type of impurity separated by a channel surmounted by a gate, an electrical contact (C1, C2) being provided on each of the diffusions and the gate in order to apply, as necessary, reading voltages (Vg, Vd, Vs), a memory characterised in that a blank cell comprises a thick oxide region (OX) separating the first diffusion into two parts (1a and 1b), one part abutting the channel and the other peripheral part (1b) carrying the electrical contact (C1) of the first diffusion, and in that a programmed cell has its first diffusion in a continuous region.

6. Memory according to Claim 5, characterised in that it is organised in a matrix in rows and columns, each row connecting the memory cell gates, each column connecting the first memory cell diffusions, the second memory cell diffusions being connected to the same potential.

7. Programmed logic array comprising memory cells according to Claim 5 or 6.
